# EUROPEAN PATENT SPECIFICATION

(11) **EP 2 277 233 B1**
(45) Date of publication and mention of the grant of the patent: **01.03.2017**
(21) Application number: 09734418.8
(22) Date of filing: 14.04.2009
(51) Int. Cl.: H01Q 1/22, H01Q 7/00, H01Q 23/00, G06K 19/07

(54) **PLANAR SENSOR STRUCTURE**
PLANARE SENSORSTRUKTUR
STRUCTURE DE DÉTECTION PLANE

(30) Priority: 21.04.2008 FI 20080301
(43) Date of publication of application: 26.01.2011
(73) Proprietor: MariCare Oy, 01450 Vantaa (FI)
(72) Inventor: ROPPONEN, Antti, FI-00400 Helsinki (FI); KRONSTRÖM, Kai, FI-00200 Helsinki (FI); AUTERINEN, Otso, FI-00100 Helsinki (FI)
(74) Representative: Heinänen Oy Patent Agency
(86) International application number: PCT/FI2009/050275
(87) International publication number: WO 2009/130373

(56) References cited:
- EP-A- 0 692 771
- WO-A-01/91080
- WO-A-2004/042668
- US-A- 4 888 581
- US-A1- 2006 140 168
- US-A1- 2008 088 460

## Description

### FIELD OF THE INVENTION

The object of this invention is a planar sensor structure, in connection with which is an antenna used in reading an escort memory tag.

### PRIOR ART

The use of a dense near-field sensor field in detecting presence is presented in patent US6407556B1, among others.

The use of pressure sensors to detect presence or movement is presented in patent US4888581A1, among others.

The use of a near-field sensor that is installed in the floor and measures an electrical connection for making observations is presented in application WO2005020171A1, among others.

The excitation used in reading an escort memory tag in prior-art solutions is sent with antenna solutions, in which the antenna is a separate unit manufactured and installed for this purpose. The placement of the antenna so that the desired coverage area of the excitation sent is implemented and so that the escort memory tags disposed in exactly the desired area react to the excitation is problematic. The placement of the antenna so that the antenna does not get broken from physical stress exerted on it and so that the antenna does not form a visual detriment or obstruction is also often problematic.

### BRIEF DESCRIPTION OF THE INVENTION

The invention presents a planar sensor structure, in which an antenna that is used in reading an escort memory tag, i.e. an RFID identifier, is disposed.

The invention is defined in the independent claim.

Optional features are set out in the dependent claims.

The sensor structure according to the invention is intended for measuring an electrical connection in order to detect the presence or movement of objects in the proximity of the sensor.

The sensor structure according to the invention can be arranged such that the structure comprises a number of sensor elements and aforementioned first conductors, and a number of second conductors, and also such that the aforementioned conductors do not cross and are not positioned on the plane of the structure at the same point with each other but instead at the distance from each other required by electrical isolation. The structure can comprise one or more sensor elements, which are applicable for use as a ground plane in measuring an electrical connection. The sensor element used as a ground plane can be e.g. such that it is suited as a ground plane when using any sensor element whatsoever in the structure for measuring an electrical connection.

The sensor structure according to the invention can consist of a conductive material, which is disposed between insulating films such that the conductive material forms a sensor element. The conductive material can be e.g. an aluminium film, the thickness of which is 0.1 mm. In addition, the structure can be arranged so that the same conductive material also forms the aforementioned first and/or second conductor. The width of the conductors formed from the film can be e.g. 0.5 mm or 2 mm, and the conductor can be of different width in different points of the structure.

The structure according to the invention can be manufactured e.g. producing a pattern from one conductive layer by printing or etching, which pattern forms at least one sensor element and the aforementioned conductors.

The planar sensor structure according to the invention can be arranged so that the sensor elements are disposed in the structure one above the other and/or side by side such that the structure divides in its longitudinal direction into stages, in each of which at least one sensor element is disposed. The structure can be arranged such that the first conductor of each sensor element and a possible second conductor connected to the sensor element or to the first conductor is disposed in the structure such that no part of them is situated in the longitudinal direction of the structure on the first side of the stage containing the aforementioned sensor element.

Further, the structure can be arranged so that a borderline running from the first edge of the structure to its second edge separates two adjacent stages, which borderline does not dissect any sensor element and does not dissect any second conductor forming a loop or first conductor connected to a sensor element more than once.

Further, the structure can be arranged so that some of the aforementioned stages are such that the second conductor forming a loop crosses with the first borderline of the stage exactly once, which second conductor does not cross with the second borderline of the aforementioned stage. A stage arranged in this way contains a loop formed by the aforementioned second conductor.

The borderline between stages can be e.g. a straight line or a freely formed line according to the position of the sensor elements and the conductors.

Further, the sensor structure divided into stages by the aforementioned borderlines can be arranged so that one or more first or second conductors passing through a stage from its first borderline to its second pass at an angle with respect to the longitudinal direction of the structure such that the displacement corresponds to the amount of first conductors of the sensor elements and second conductors of the loops in the stage in question.

Yet again, the structure can be arranged so that adjacent stages are identical in terms of the shape and placement of a part or all of the conductors and sensor elements in it.

Further, a structure comprising consecutive stages that are identical in the aforesaid manner can be arranged so that the mat of the stage in the longitudinal direction, including the first and the second borderline, comprises a plurality of junctures disposed on the borderline such that both borderlines have a juncture at the same certain point of the borderline. When the junctures are numbered with the index i, which receive the values 1 .. L, where L is the number of junctures, the juncture corresponding to the index i of the first borderline is connected with the conductor passing through the stage to the juncture of the second borderline, which juncture corresponds to the value i + K of the index, if this value is not greater than L, where K is the aggregate amount of sensor elements and loops disposed in the stage. The first conductors connected to the sensor elements disposed in a stage and the second conductors forming the loops disposed in the stage are connected to the junctures of the second borderline, which correspond to the values 1 .. K of the index. Those junctures of the first borderline of the stage, for which the value i + K of the index i is greater than L, are not connected with a conductor of the structure to the juncture of the second borderline of the same stage. The values of the index i of the junctures presented do not need to correspond to the sequence of the junctures on the borderline, but a certain value of the index corresponds to the same location of the juncture on both the borderlines of the stage.

The structure according to the invention can be arranged so that from one to nine sensor elements, or many sensor elements, remain inside the loop formed by the second conductor. For example, in a linear structure, which comprises three sensor elements side-by-side, the second conductor can form a loop that extends in the longitudinal direction such that altogether nine sensor elements remain inside it.

The structure can be arranged so that the first and second conductors of two or more adjacent stages are disposed on the same side of the stage in the longitudinal direction of the structure.

The structure can be arranged so that the conductors connected to the sensor elements or loops of each stage extend in the structure to a certain distance from the stage in the longitudinal direction of the structure. The structure can be e.g. such that the first and second conductors pass through e.g. six or ten stages in the structure.

The structure can be arranged so that the first conductor of a sensor element extends in the structure to a certain distance in the longitudinal direction of the structure and the second conductor connected to the same sensor element or to the first conductor of it extends in the same direction to a certain different distance than the aforementioned first conductor. The structure can be e.g. such that the first and second conductors extend in the structure e.g. to a distance of three stages from the stage in which the sensor element is disposed, and the second conductors correspondingly to a distance of two elements.

The structure according to the invention can be arranged so that the first and second conductors pass on one or both edges of a structure comprising repetitive stages, in another point or in a number of points as viewed in the lateral direction of the structure. The structure can be e.g. such that the conductor connected to the sensor elements that are used as a ground plane passes on both edges of the structure and the other conductors in the center part of the structure.

In the structure according to the invention the sequence between the conductors at the point of the borderline of a stage can be such that the first conductors are in the same sequence with respect to each other as the sequence in which the corresponding sensors are disposed in the longitudinal direction of the structure. Further, the second conductors can be disposed next to the type of first conductor, which is connected to a sensor remaining inside a loop formed by the second conductor.

The structure can be arranged such that it can be manufactured to be continuous, so that the stage according to the pattern formed by the first conductor, the sensor element and the second conductor is repeated in it for the full longitudinal direction.

The structure according to the invention can e.g. be manufactured as a film-like mat, from which the necessary patches can be cut, which can be installed next to each other e.g. as a sensor field between the surface material of the floor and another structure of the floor. With the structure according to the invention measuring electronics can be connected to the manufactured sensor field e.g. by disposing a measuring apparatus at the end of the structure, which is formed by cutting the mat along the borderline of the stages or at some other point.

An advantage of the structure according to the invention with respect to prior art solutions is that the same structure can be advantageously used for sending an excitation used in reading an escort memory tag by connecting a suitable radio-frequency current to the loop and also e.g. as a sensor field that measures an electrical connection for detecting the presence and movement of objects, in which changes in a capacitive connection are measured e.g. between each sensor and the structure surrounding the sensor or between each sensor and other electrodes.

An advantage of the structure according to the invention can be that the excitation used in reading an escort memory tag is sent with the antenna solutions already implemented in connection with the sensor field without separate manufacturing or installation. Further, an advantage can be that the desired coverage area of the excitation sent can be implemented by using an antenna situated in exactly the right location, in which case the escort memory tags disposed in exactly the desired area react to the excitation. A further advantage can be that many antennas can be advantageously disposed in the structure and that they do not break easily from physical stress and they do not form a visual detriment or impediment.

An advantage of the structure according to the invention can be that the space taken by the conductors passing in the longitudinal direction of the structure is saved on the plane of the structure especially in its lateral direction. Two different conductors are not needed for one antenna formed by a loop. The distance required by e.g. the insulation between each conductor and the conductors takes space which, on the one hand, reduces the space in the width direction of the structure to be used for sensor electrodes and, on the other hand, limits the amount of conductors that fit in the structure, which in turn limits the amount of stages and sensor electrodes used and thus the maximum length of the viable mat to be installed. In the structure according to the invention, two antenna conductors are not needed in the longitudinal direction of the structure because the conductor of the sensor element is used as the second antenna conductor.

### DETAILED DESCRIPTION OF THE INVENTION

In the following the invention will be described in more detail with reference to the embodiments and to the attached drawings, wherein
Fig. 1 presents two alternative sensor structures comprising one loop according to one embodiment of the invention.
Fig. 2 presents a sensor structure comprising a number of loops according to a second embodiment of the invention.
Fig. 3 presents a sensor structure comprising a number of loops according to a third embodiment of the invention.
Fig. 4 presents a sensor structure comprising repetitive stages according to a third embodiment of the invention and the passage of the conductors on the borderline of the stages.

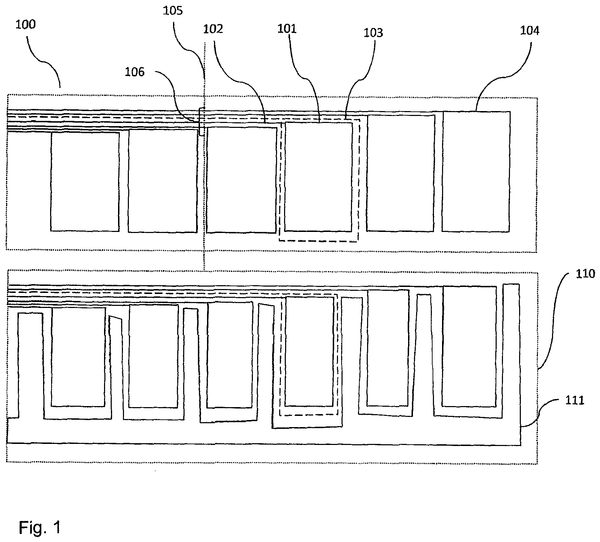

Fig. 1 presents a sensor structure (100), which comprises six conductive sensor elements, according to one embodiment of the invention. One of the sensor elements (101) and the first conductor (102) connected to it are arranged such that the conductor (102) forms together with a second conductor (103) a loop according to the invention, which is suited for sending a radio-frequency excitation used in the reading of an escort memory tag. The other sensor elements of the structure, e.g. that on the extreme right-hand side in the figure (104) or the first conductors connected to them are not connected to second conductors. All the conductors in the figure pass in the structure to the left-hand edge of it, on which can be installed a radio apparatus used for sending an excitation, an electronic apparatus or a connector used in measuring, to which the conductors connected to the radio apparatus or measuring apparatus are connected. The sensor structure (100) can be used when shorter by truncating it e.g. at any point whatsoever on the left-hand side of a sensor element (101) such that the loop remains intact and a new edge of the structure is created which can be used in the manner of the edge of the original structure for connecting conductors or an electronic apparatus. One possible truncation point (105), and the placement point (106) of the connector or apparatus corresponding to this, is marked in the figure. A connector similar to the connector in the case of an uncut structure (100), which penetrates the structure with pins at the point of each film-like conductor, can be used in this point. In the case of a connector comprising seven pins, here the two lowermost pins in the figure penetrate the structure at a point where there is no conductor. It is advantageous to use the structure (100) in solutions in which an excitation loop according to the invention is installed in the center section of the sensor field, from where the excitation to be sent reaches the desired space.

Fig. 1 also presents a structure (110), similar to the structure (100), according to a second embodiment of the invention, which comprises an element (111) used as a ground plane. This ground plane can be used for measuring an electrical connection with any second sensor element whatsoever of the same structure (110).

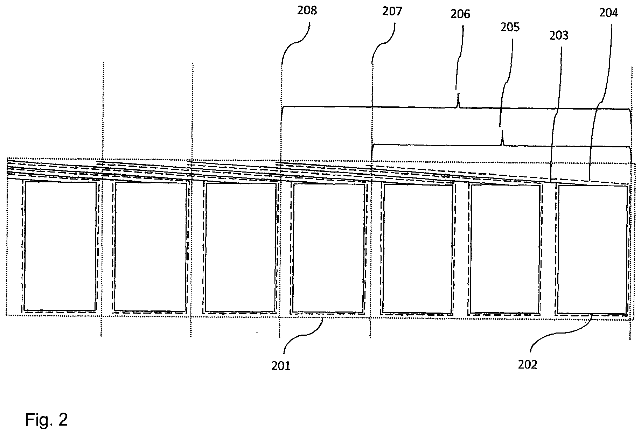

Fig. 2 presents the planar sensor structure (201) of a second embodiment of the invention, which comprises seven conductive sensor elements. A first conductor is connected to each sensor element, to which first conductor a second conductor is fitted such that a loop surrounding one sensor element is formed. In the figure the first conductor (203) of the sensor element (202) on the extreme right-hand side extends for a distance (206) of three sensor elements from the element (202). The second conductor (204) connected to the first conductor (203) of the same sensor element (202) extends for a distance of two sensor elements from the aforementioned element (202). The sensor structure (201) can be truncated at the point (207), in which case two sensor elements are formed. The part on the extreme right-hand side of the structure forms a structure that is disposed at the point (205) of the structure and comprises three sensor elements and three loops. At the point (207) on the left-hand edge of this structure is a point to which a connector, measuring apparatus and/or radio apparatus to be connected to the conductors of the structure can be installed. On the left-hand side of the truncation point (207) a sensor structure comprising four sensor elements and four loops is formed. The left-hand edge of this structure comprises a point to which a connector or measuring apparatus, which is connected to four first conductors and three second conductors, can be installed. This structure comprises three loops suited to sending an excitation used in reading an escort memory tag. The structure (201) comprises a second truncation point (208), by using which a structure of functionally the same type as the structure remaining on the left-hand side of the first truncation point (207) is formed. The structure (201) also comprises other advantageous truncation points, by using which the necessary sensor structure can be formed from the structure. The juncture of five conductors of the truncation point (207) is connected to the junctures of the truncation point (208) on the second borderline of the stage of the structure such that the two innermost junctures are used for the conductors of the sensor element and loop disposed in the stage.
The two junctures of the truncation point (207) that are nearest the edge of the structure are not connected to the second borderline of the stage.

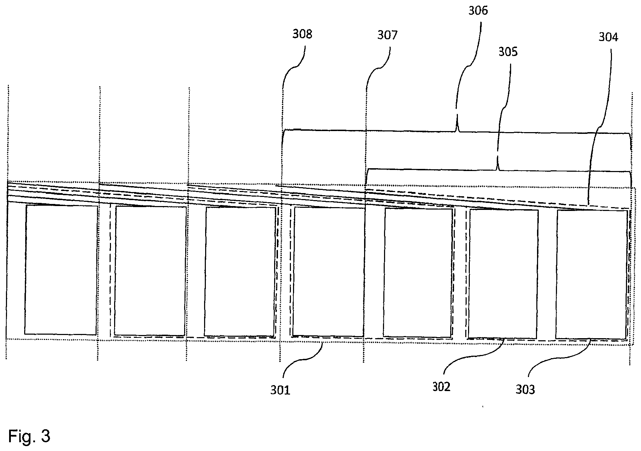

Fig. 3 presents the planar sensor structure (301) according to a third embodiment of the invention, which comprises seven conductive sensor elements, The sensor structure is similar to what is presented in Fig. 2.
The second conductors of the structure are arranged differently than in the structure presented in Fig. 2. The second conductor that is connected to the first conductor connected to the sensor element (302) forms a loop, inside of which remains the sensor element (303) in addition to the element (302). For example, the structure (305) or (306) can be formed from the structure (301) by truncating. By using the truncation point (307) a structure (305) is formed that comprises three sensor elements and one conductor loop, inside which remain two sensor elements (302,303). This loop is suited to sending an excitation according to the invention. By using the truncation point (308) a structure is formed from the left-hand part of the structure (301) that is functionally identically with the structure (305). By using the same truncation point (308) a structure (306) is formed from the part remaining on the right-hand side of it, which comprises four sensor elements, which remain as two pairs each of which is inside a separate conductor loop according to the invention. The second loop passes around the elements (302 and 303), but the second conductor of this loop does not extend to the truncation point (308), and thus cannot be connected to a connector or apparatus installed on the truncation point without a separate conductor.

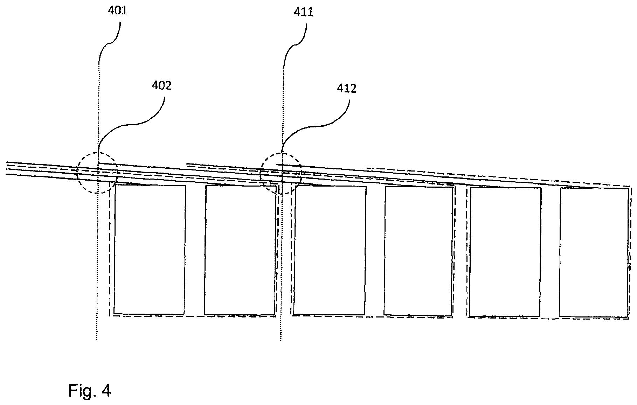

Fig. 4 presents a sensor structure comprising repetitive stages according to a third embodiment of the invention. The figure presents a repetitive stage of the structure which is delimited between the borderlines (401) and (411). Both borderlines have a plurality of crossing points of conductors and a borderline, which form the junctures of consecutive stages. The junctures of the first borderline of the stage between the borderlines (401) and (411) are in the area (412) and the junctures of the second borderline are in the area (402). The junctures are numbered in the figure from bottom to top with the numbers 1 .. 5. The junctures 1 and 2 of the first borderline are connected with a conductor running in the stage to the junctures 4 and 5 of the second borderline. The sensor elements disposed in the stage are connected with conductors to the junctures 1 and 2 of the second borderline, and the conductor forming a loop disposed in the stage to the juncture 3.

It is also obvious to the person skilled in the art that the embodiments presented above are for the sake of clarity comparatively simple in their structure and function. Following the model presented in this patent application it is possible to construct different and also very complex solutions that utilize the inventive concept presented in this patent application.

## Claims

1. Planar sensor structure configured for measuring electrical coupling in order to detect the presence or movement of objects in the proximity of the sensor, which comprises:
at least one planar sensor element and a first conductor connected to it,
**characterized in that**
a second conductor is connected to the aforementioned sensor element such that the first conductor and the second conductor together with the aforementioned sensor element form a loop that is configured for sending an excitation used in reading an escort memory tag, or
a second conductor is connected to the aforementioned first conductor such that the first conductor and the second conductor form a loop that is configured for sending an excitation used in reading an escort memory tag,
wherein the loop is formed in such a way that at least one sensor element remains inside the loop.

2. Planar sensor structure according to claim 1, **characterized in that**
the planar sensor structure is a continuous structure and arranged so that a pattern formed by the first conductor, the sensor element and the second conductor is repeated in the full longitudinal direction.

3. Planar sensor structure according to claim 1 or 2, **characterized in**
**that** the loop is formed in such a way that at least two sensor elements remain inside the loop, and the structure is arranged such that the aforementioned at least two sensor elements are arranged one above the other or side by side such that the structure divides into at least two stages on at least one borderline passing through it, in each of which stages at least one sensor element is disposed, and also such that the first conductor connected to at least one sensor element disposed in each stage crosses with the first borderline of the aforementioned stage, and also such that the possible aforementioned second conductor connected to the sensor element disposed in the aforementioned stage or to the first conductor connected to it does not cross with any other borderline of the aforementioned stage than with the aforementioned first borderline.

4. Planar sensor structure according to claim 3, **characterized in that**
the aforementioned conductors and sensor elements form a structure, in which
the aforementioned at least two stages comprise the same pattern on the plane of the structure formed from the sensor elements, the first and the second conductors, which pattern is arranged such that there is a borderline between each two stages extending from one edge of the structure to the other, on which borderline is a plurality of junctures such that on the first and the second borderline of a stage is a juncture on the same certain point of the borderline such that when the junctures of the borderlines are numbered with the index i, which receives the values 1 .. L, where L is the number of junctures, and the aggregate number of sensor elements disposed in a certain stage and loops disposed in a stage is K, the first conductors connected to the sensor elements disposed in a stage and the second conductors forming the loops disposed in the stage meet at the junctures of the second borderline, which have the index values 1 .. K, and also such that the conductor meeting juncture i+K of the second borderline of the same stage passes through the stage without crossing with any conductor of the structure and meets the first borderline at the juncture i on it.

5. Planar sensor structure according to claim 4, **characterized in that** in
the aforementioned stage the junctions disposed on its borderlines are connected such that the first conductor connected to a sensor element in a certain stage extends in the longitudinal direction of the structure through the adjacent stages longer than the second conductor connected to the sensor element disposed in the aforementioned stage or to the first conductor connected to it.

6. Planar sensor structure according to any previous claim,
**characterized in that** the structure comprises a conductive planar element, which is suited for use as a ground plane or as a similar type of means when using some sensor element, some sensor elements or all the said sensor elements for measuring an electrical connection.

7. Planar sensor structure according to any previous claim,
**characterized in that** the structure is arranged so that the aforementioned first and second conductors do not cross.

8. Planar sensor structure according to any previous claim, **characterized in that** the structure is suited to measuring an electrical connection in order to detect the presence or movement of objects in the proximity of it.

9. Planar sensor structure according to any previous claim,
**characterized in that** at least one aforementioned second conductor forms a loop, inside which at most 9 sensor elements remain.

## Patentansprüche

1. Planare Sensorstruktur, die zur Messung einer elektrischen Kopplung eingerichtet ist, um die Gegenwart oder Bewegung von Objekten in der Nähe des Sensors zu detektieren, die aufweist:
wenigstens ein planares Sensorelement und einen ersten Leiter, der mit diesem verbunden ist,
**dadurch gekennzeichnet, dass**
ein zweiter Leiter mit dem vorerwähnten Sensorelement derart verbunden ist, dass der erste Leiter und der zweite Leiter gemeinsam mit dem vorerwähnten Sensorelement eine Schleife bilden, die zur Sendung einer Anregung eingerichtet ist, die zum Lesen einer begleitenden Speicheretikette verwendet wird, oder
ein zweiter Leiter mit dem vorerwähnten ersten Leiter derart verbunden ist, dass der erste Leiter und der zweite Leiter eine Schleife bilden, die zum Senden einer Anregung eingerichtet ist, die zum Lesen einer begleitenden Speicheretikette verwendet wird,
wobei die Schleife in einer derartigen Weise ausgebildet ist, dass wenigstens ein Sensorelement innerhalb der Schleife verbleibt.

2. Planare Sensorstruktur nach Anspruch 1, **dadurch gekennzeichnet, dass** die planare Sensorstruktur eine kontinuierliche Struktur und derart angeordnet ist, dass sich ein durch den ersten Leiter, das Sensorelement und den zweiten Leiter gebildetes Muster in der vollen Längsrichtung wiederholt.

3. Planare Sensorstruktur nach Anspruch 1 oder 2,
**dadurch gekennzeichnet, dass** die Schleife in einer derartigen Weise ausgebildet ist, dass wenigstens zwei Sensorelemente innerhalb der Schleife verbleiben, und die Struktur derart angeordnet ist, dass die vorerwähnten wenigstens zwei Sensorelemente übereinander oder nebeneinander angeordnet sind, so dass die Struktur an wenigstens einer durch diese hindurchführenden Grenzlinie in wenigstens zwei Stufen unterteilt ist, wobei in jeder der Stufen wenigstens ein Sensorelement angeordnet ist, und auch so, dass sich der erste Leiter, der mit wenigstens einem Sensorelement verbunden ist, der in jeder Stufe angeordnet ist, mit der ersten Grenzlinie der vorerwähnten Stufe kreuzt, und auch so, dass sich der mögliche vorerwähnte zweite Leiter, der mit dem Sensorelement, das in der vorerwähnten Stufe angeordnet ist, oder mit dem mit diesem verbundenen ersten Leiter verbunden ist, nicht mit irgendeiner anderen Grenzlinie der vorerwähnten Stufe als mit der vorerwähnten ersten Grenzlinie kreuzt.

4. Planare Sensorstruktur nach Anspruch 3, **dadurch gekennzeichnet, dass** die vorerwähnten Leiter und Sensorelemente eine Struktur bilden, in der die vorerwähnten wenigstens zwei Stufen das gleiche Muster auf der Ebene der Struktur aufweisen, das von den Sensorelementen, dem ersten und dem zweiten Leiter gebildet ist, wobei das Muster derart angeordnet ist, dass eine Grenzlinie zwischen jeweils zwei Stufen vorliegt, die sich von einem Rand der Struktur zu dem anderen erstreckt, wobei sich auf der Grenzlinie mehrere Verbindungspunkte derart befinden, dass sich auf der ersten und der zweiten Grenzlinie einer Stufe ein Verbindungspunkt an demselben bestimmten Punkt der Grenzlinie befindet, so dass,
wenn die Verbindungspunkte der Grenzlinien mit dem Index i nummeriert werden, der die Werte 1 ... L erhält, wobei L die Anzahl der Verbindungspunkte ist, und die Gesamtzahl von Sensorelementen, die in einer bestimmten Stufe und in in einer Stufe angeordneten Schleifen angeordnet sind, K ist, die ersten Leiter, die mit den in einer Stufe angeordneten Sensorelementen verbunden ist, und die zweiten Leiter, die die in der Stufe angeordneten Schleifen bilden, an den Verbindungspunkten der zweiten Grenzlinie zusammentreffen, die die Indexwerte 1 ... K haben, und auch so, dass der Leiter, der auf den Verbindungspunkt i+K der zweiten Grenzlinie derselben Stufe trifft, durch die Stufe verläuft, ohne sich mit irgendeinem Leiter der Struktur zu kreuzen, und mit der ersten Grenzlinie an dem Verbindungspunkt i auf dieser zusammentrifft.

5. Planare Sensorstrukturen nach Anspruch 4, **dadurch gekennzeichnet, dass** in der vorerwähnten Stufe die auf ihren Grenzlinien angeordneten Verbindungspunkte derart verbunden sind, dass der erste Leiter, der mit einem Sensorelement in einer bestimmten Stufe verbunden ist, sich in der Längsrichtung der Struktur durch die benachbarten Stufen länger als der zweite Leiter erstreckt, der mit dem in der vorerwähnten Stufe angeordneten Sensorelement oder mit dem mit diesem verbundenen ersten Leiter verbunden ist.

6. Planare Sensorstruktur nach einem beliebigen vorhergehenden Anspruch, **dadurch gekennzeichnet, dass** die Struktur ein leitfähiges planares Element aufweist, das sich zur Verwendung als eine Massefläche oder als eine ähnliche Art von Einrichtung eignet, wenn irgendein Sensorelement, irgendwelche Sensorelemente oder all die Sensorelemente zur Messung einer elektrischen Verbindung verwendet wird bzw. werden.

7. Planare Sensorstruktur nach einem beliebigen vorhergehenden Anspruch, **dadurch gekennzeichnet, dass** die Struktur derart angeordnet ist, dass sich der erste und der zweite Leiter nicht kreuzen.

8. Planare Sensorstruktur nach einem beliebigen vorhergehenden Anspruch, **dadurch gekennzeichnet, dass** sich die Struktur zur Messung einer elektrischen Verbindung eignet, um die Gegenwart oder Bewegung von Objekten in deren Nähe zu detektieren.

9. Planare Sensorstruktur nach einem beliebigen vorhergehenden Anspruch, **dadurch gekennzeichnet, dass** wenigstens ein vorerwähnter zweiter Leiter eine Schleife bildet, innerhalb derer höchstens 9 Sensorelemente verbleiben.

## Revendications

1. Structure de détection plane configurée pour mesurer un couplage électrique afin de détecter la présence ou le déplacement d'objets à proximité du capteur, qui comprend :
au moins un élément plan de détection et un premier conducteur connecté à celui-ci,
**caractérisée en ce que**
un deuxième conducteur est connecté à l'élément capteur précédemment mentionné, de telle sorte que le premier conducteur et le deuxième conducteur conjointement avec l'élément capteur précédemment mentionné forment une boucle qui est configurée pour envoyer une excitation utilisée lors de la lecture d'une étiquette mémoire d'accompagnement, ou
un deuxième conducteur est connecté au premier conducteur précédemment mentionné, de telle sorte que le premier conducteur et le deuxième conducteur forment une boucle qui est configurée pour envoyer une excitation utilisée lors de la lecture d'une étiquette mémoire d'accompagnement,
dans laquelle la boucle est formée de telle sorte qu'au moins un élément capteur reste à l'intérieur de la boucle.

2. Structure de détection plane selon la revendication 1, **caractérisée en ce que** la structure de détection plane est une structure continue et agencée de sorte qu'un motif formé par le premier conducteur, l'élément capteur et le deuxième conducteur est répété dans toute la direction longitudinale.

3. Structure de détection plane selon la revendication 1 ou 2, **caractérisée en ce que** la boucle est formée de telle manière qu'au moins deux éléments capteurs restent à l'intérieur de la boucle, et la structure est agencée de telle sorte que les deux éléments capteurs précédemment mentionnés ou plus sont agencés les uns au-dessus des autres ou côte-à-côte de telle sorte que la structure se divise en au moins deux étages sur au moins une limite passant à travers celle-ci, étages dans chacun desquels au moins un élément capteur est disposé, et également de telle sorte que le premier conducteur connecté à l'élément ou aux éléments capteurs disposés dans chaque étage croise la première limite de l'étage précédemment mentionné, et également de telle sorte que le deuxième conducteur possible précédemment mentionné connecté à l'élément capteur disposé dans l'étage précédemment mentionné ou au premier conducteur connecté à celui-ci ne croise aucune autre limite de l'étage précédemment mentionné que la première limite précédemment mentionnée.

4. Structure de détection plane selon la revendication 3, **caractérisée en ce que** les conducteurs et les éléments capteurs précédemment mentionnés forment une structure, dans laquelle les deux étages précédemment mentionnés ou plus comprennent le même motif sur le plan de la structure formé par les éléments capteurs, les premiers et les deuxièmes conducteurs, lequel motif est agencé de telle sorte qu'il existe une limite entre chacun des deux étages s'étendant d'un bord de la structure à l'autre, limite sur laquelle se situent une pluralité de jonctions de telle sorte que sur la première et la deuxième limite d'un étage se situe une jonction sur le même certain point de la limite, de telle sorte que, lorsque les jonctions des limites sont numérotées avec l'indice i, qui reçoit les valeurs 1...L, dans lequel L est le nombre de jonctions, et le nombre agrégé d'éléments capteurs disposés dans un certain étage et de boucles disposées dans un étage est K, les premiers conducteurs connectés aux éléments capteurs disposés dans un étage et les deuxièmes conducteurs formant les boucles disposées dans l'étage se rejoignent aux jonctions de la deuxième limite, qui présentent les valeurs d'indice 1...K, et également de telle sorte que la jonction de rencontre des conducteurs i+K de la deuxième limite du même étage passe à travers l'étage sans croiser de conducteur de la structure et rejoint la première limite au niveau de la jonction i sur celle-ci.

5. Structure de détection plane selon la revendication 4, **caractérisée en ce que** dans l'étage précédemment mentionné, les jonctions disposées sur ses limites sont connectées de telle sorte que le premier conducteur connecté à un élément capteur dans un certain étage s'étend dans la direction longitudinale de la structure à travers les étages adjacents sur une plus grande longueur que le deuxième conducteur connecté à l'élément capteur disposé dans l'étage précédemment mentionné ou au premier conducteur connecté à celui-ci.

6. Structure de détection plane selon l'une quelconque des revendications précédentes, **caractérisée en ce que** la structure comprend un élément conducteur plan, qui est adapté à être utilisé comme retour de masse ou comme type similaire de moyens lors de l'utilisation d'un certain élément capteur, de certains éléments capteurs ou de tous lesdits éléments capteurs destinés à mesurer une connexion électrique.

7. Structure de détection plane selon l'une quelconque des revendications précédentes, **caractérisée en ce que** la structure est agencée de sorte que les premiers et deuxièmes conducteurs précédemment mentionnés ne se croisent pas.

8. Structure de détection plane selon l'une quelconque des revendications précédentes, **caractérisée en ce que** la structure est adaptée à mesurer une connexion électrique afin de détecter la présence ou le déplacement d'objets à proximité de celle-ci.

9. Structure de détection plane selon l'une quelconque des revendications précédentes, **caractérisée en ce qu'**au moins un deuxième conducteur précédemment mentionné forme une boucle, à l'intérieur de laquelle résident au maximum 9 éléments capteurs.
